# EUROPÄISCHE PATENTSCHRIFT

(11) **EP 0 351 569 B1**
(45) Veröffentlichungstag und Bekanntmachung des Hinweises auf die Patenterteilung: **25.08.1993**
(21) Anmeldenummer: 89111253.4
(22) Anmeldetag: 20.06.1989
(51) Int. Cl.: C25D 17/00

(54) **Galvanisiereinrichtung für plattenförmige Werkstücke, insbesondere Leiterplatten**
Apparatus for electroplating platelike articles, particularly circuit boards
Dispositif pour l'électroplacage des articles en forme de plaques en particulier des plaques de circuits

(30) Priorität: 07.07.1988 DE 3823071
(43) Veröffentlichungstag der Anmeldung: 24.01.1990
(73) Patentinhaber: Siemens Nixdorf Informationssysteme Aktiengesellschaft, 33102 Paderborn (DE)
(72) Erfinder: Hosten, Daniel, B-8120 Handzame (BE)
(74) Vertreter: Fuchs, Franz-Josef, Dr.-Ing.

(56) Entgegenhaltungen:
- EP-A- 0 254 030
- EP-A- 0 254 962
- DE-A- 3 703 549

## Beschreibung

Die Erfindung betrifft eine Galvansiereinrichtung für im horizontalen Durchlauf zu behandelnde plattenförmige Werkstücke, insbesondere Leiterplatten, mit mehreren im Abstand zueinander seitlich mit dem Werkstück verfahrbaren Kontaktklemmen zur kathodischen Kontaktierung der durchlaufenden Werkstücke, wobei der Kathodenstrom den Kontaktklemmen über mindestens eine Stromschiene und über Kontaktorgane mittels Schleifkontaktierung zuführbar ist.

Eine derartige Galvanisiereinrichtung ist aus der EP-A-0 254 962 bekannt. Die zu galvanisierenden Werkstücke, bei welchen es sich insbesondere um Leiterplatten handelt, werden auf einer horizontalen Durchlaufbahn durch die Elektrolytlösung enthaltende Behandlungszelle geführt. Um eine sichere kathodische Kontaktierung der durchlaufenden Werkstücke zu gewährleisten, ist mindestens eine seitlich mit dem Werkstück verfahrbare, zangenförmige Kontaktklemme vorgesehen. Vorzugsweise ist ein endloser Trieb als verfahrbarer Träger mehrerer im Abstand zueinander angeordneter Kontaktklemmen vorgesehen, wobei dieser Trieb dann auch als Transporteinrichtung für die Werkstücke dient. Bei einem der beschriebenen Ausführungsbeispiele sind ein oberer und ein unterer Zahnriemen vorgesehen, wobei die Zufuhr des Kathodenstroms zu den Klemmbacken der Kontaktklemmen in diesem Fall über Kontaktorgane in Form von Bürsten erfolgt.

Auch bei einer aus der DE-A-3 624 481 bekannten Galvanisiereinrichtung für im horizontalen Durchlauf zu behandelnde plattenförmige Werkstücke erfolgt die Zufuhr des Kathodenstroms zu endlos umlaufenden Kontaktklemmen über eine stationäre Bürstenanordnung, die an den Kontaktklemmen anliegt.

Die vorstehend beschriebene kathodische Kontaktierung plattenförmiger Werkstücke ist gegenüber einer Berührung mit Elektrolytlösung weitaus weniger empfindlich als Rollkontakte und Schleifkontakte. Im Hinblick auf die erforderliche Verfahrbarkeit der Kontaktklemmen ist jedoch nach wie vor eine Stromübertragung zwischen stationären und bewegten Teilen erforderlich, wobei die entsprechende Kontaktierung nun aber in einen vor dem Zutritt von Elektrolytlösung und anderen negativen Einflüssen geschützten Bereich verlegt werden kann. Beim Galvanisieren mit Stromdichten von beispielsweise 10 A/dm² und mehr ergibt sich eine hohe Wärmebelastung im Bereich der Stromübertragung zwischen ruhenden und bewegten Teilen. Insbesondere bei der Verwendung von Bürstenanordnungen werden bei derartigen Stromdichten die Bürsten stark erhitzt, so daß ein frühzeitiger Verschleiß dieser Bürsten auftritt.

Der Erfindung liegt die Aufgabe zugrunde, bei einer Galvanisiereinrichtung der eingangs genannten Art die kathodische Kontaktierung der durchlaufenden Werkstücke im Hinblick auf die Wärmebelastung und den daraus resultierenden Verschleiß zu verbessern, wobei gleichzeitig die erforderliche Korrosionsbeständigkeit gewährleistet sein soll.

Diese Aufgabe wird erfindungsgemäß durch folgende Merkmale gelöst:
a) die Stromschiene besitzt einen Kern aus einem Material mit hohem elektrischen Leitvermögen und eine Ummantelung aus einem Material mit hoher Korrosionsbeständigkeit,
b) als Kontaktorgane sind Kontaktfedern vorgesehen, die aus einem Material mit hoher Korrosionsbeständigkeit bestehen,
c) die Kontaktfedern sind mit der Stromschiene mechanisch und elektrisch leitend verbunden.

Der Erfindung liegt die Erkenntnis zugrunde, daß mit einer massiv ausgebildeten Stromschiene aus einem Material mit hohem elektrischen Leitvermögen sehr hohe Ströme an daran befestigte Kontaktfedern übertragen werden können, sofern die Stromschiene durch eine Ummantelung aus einem Material mit hoher Korrosionsbeständigkeit geschützt wird und auch die Kontaktfedern selbst aus einem derartigen korrosionsbeständigen Material bestehen. Eine zu starke Erhitzung der stromübertragenden Teile und ein dadurch bedingter frühzeitiger Verschleiß können dabei vermieden werden.

Im Hinblick auf die Auswahl der Werkstoffe hat es sich als besonders günstig erwiesen einen Kern aus Kupfer oder einer Kupferlegierung, eine Ummantelung aus Titan oder einer Titanlegierung und ebenso Kontaktfedern aus Titan oder einer Titanlegierung zu verwenden.

Die mechanisch und elektrisch leitende Verbindung zwischen den Kontaktfedern und der Stromschiene wird auf einfache Weise und äußerst effektiv durch Schweißen vorgenommen, wobei sich insbesondere das Punktschweißen bewährt hat.

Weiterhin hat es sich im Hinblick auf die Erwärmung der Kontaktfedern als vorteilhaft herausgestellt, wenn in die Kontaktfedern mindestens ein sich in Durchlaufrichtung erstreckender Schlitz eingebracht ist.

Ein Ausführungsbeispiel der Erfindung ist in der Zeichnung dargestellt und wird um folgenden näher beschrieben.

### Es zeigen

- Fig. 1: einen Schnitt durch die kathodische Kontaktiervorrichtung einer Galvanisiereinrichtung für im horizontalen Durchlauf zu behandelnde Leiterplatten,
- Fig. 2: eine teilweise geschnittene Draufsicht auf die Kontaktiervorrichtung nach Fig. 1 und
- Fig. 3: eine perspektivische Darstellung von Stromschiene und Kontaktfedern der in den Fig. 1 und 2 dargestellten Kontaktiervorrichtung.

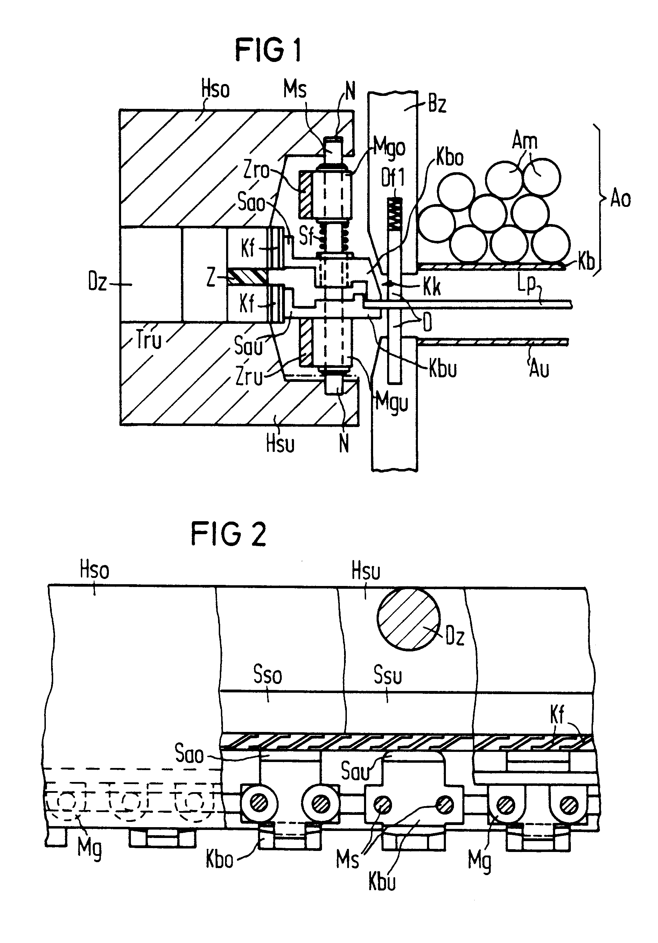

Die Fig. 1 und 2 zeigen im Schnitt bzw. in der teilweise aufgebrochenen Draufsicht die kathodische Kontaktierung einer Galvanisiereinrichtung für im horizontalen Durchlauf zu behandelnde Leiterplatten. Eine derartige Galvanisiereinrichtung ist beispielsweise in der EP-A-O 254 962 beschrieben.

Bei der dargestellten Kontaktiervorrichtung sind am linken Bildrand der Fig. 1 die seitliche Wandung einer Behandlungszelle Bz, eine obere Anode Ao mit einem Korb Kb und dem darin enthaltenen Anodenmaterial Am, die zu galvanisierende Leiterplatte Lp und eine untere Anode Au zu erkennen. Die Leiterplatte Lp ist mit ihrem seitlichen Randbereich durch die Wandung der Behandlungszelle Bz hindurchgeführt, wobei die hierzu erforderliche, sich in Durchlaufrichtung schlitzförmig erstreckende Öffnung durch eine Dichtung D verschlossen ist. Die Dichtung D besteht aus einer unteren, fest angeordneten Dichtleiste und einer oberen, in vertikaler Richtung beweglichen Dichtleiste, die über Druckfedern Df gegen die Leiterplatte Lp gedrückt wird. Die beispielsweise aus Polytetrafluoräthylen bestehenden Dichtleisten der Dichtung D haben die Aufgabe sich an die Oberfläche der durchlaufenden Leiterplatten Lp anzuschmiegen und einen Austritt von Elektrolytlösung zumindest weitgehend zu verhindern.

Der über die Dichtung D seitlich überstehende Rand der Leiterplatten Lp wird zur kathodischen Kontaktierung von mehreren, im Abstand zueinander angeordneten und zangenförmig ausgebildeten Kontaktklemmen Kk erfaßt. Jede dieser Kontaktklemmen Kk besteht aus einer oberen Klemmbacke Kbo und einer unteren Klemmbacke Kbu, wobei beide Klemmbacken auf einem vertikal ausgerichteten Mitnehmerstift Ms verschiebbar angeordnet sind. Der Mitnehmerstift Ms ist seinerseits in den Mitnehmergliedern Mgo und Mgu eines oberen Zahnriemens Zro bzw. eines unteren Zahnriemens Zru gehalten. Die beiden Zahnriemen Zro und Zru, die gegebenenfalls auch als Ketten ausgebildet sein können, bilden jeweils einen endlosen Trieb als verfahrbarer Träger für die Kontaktklemmen Kk. Die oberen Enden der Mitnehmerstifte Ms der einzelnen Kontaktklemmen Kk sind zusätzlich noch in einer U-förmigen Nut N einer oberen Halteschiene Hso geführt, während die unteren Enden in der entsprechenden Nut N einer unteren Halteschiene Hsu geführt sind. Die obere und die untere Halteschiene Hso und Hsu, die beispielsweise aus hochmolekularem Polyäthylen bestehen, sind über Distanzbolzen Dz fest miteinander verbunden. Die Längsführung der Mitnehmerstifte Ms der Kontaktklemmen Kk in den beiden Nuten N beschränkt sich auf den Bereich in dem die Leiterplatten Lp kathodisch kontaktiert werden sollen und in dem die beiden Zahnriementriebe mit den Kontaktklemmen Kk gleichzeitig die Aufgabe einer Transporteinrichtung für den horizontalen Durchlauf der Leiterplatten Lp erfüllen. In dem Umlenkbereichen eines jeden Zahnriementriebes und im bereich des rücklaufenden Trums entfällt diese Führung.

Zwischen dem oberen Zahnriemen Zro und dem unteren Zahnriemen Zru sind auf jeweils zwei Mitnehmerstiften Ms die oberen Klemmbacken Kbo und die unteren Klemmbacken Kbu der Kontaktklemmen Kk beweglich geführt. Der zum Schließen der Kontaktklemmen Kk und zur sicheren Kontaktierung der Leiterplatten Lp erforderliche Druck wird durch Schließfedern Sf aufgebracht, die jeweils zwischen den Mitnehmergliedern Mg und den oberen Klemmbacken Kbo auf den Mitnehmerstiften Ms angeordnet sind.

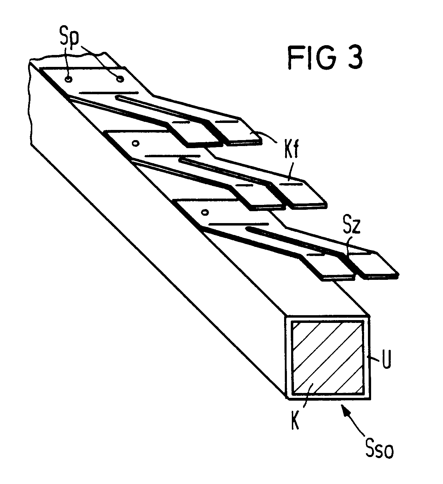

An die obere Klemmbacke Kbo ist rückseitig ein winkelförmiger Stromabnehmer Sao angeformt, der zur Übertragung des Kathodenstroms auf Kontaktfedern Kf gleitet, die an einer oberen Stromschiene Sso befestigt sing. In entsprechender Weise ist an die untere Klemmbacke Kbu rückseitig ein winkelförmiger Stromabnehmer Sau angeformt, der zur Übertragung des Kathodenstroms auf Kontaktfedern Kf gleitet, die an einer unteren Stromschiene Ssu befestigt sind. Die Stromschienen Sso und Ssu, deren Aufbau an späterer Stelle anhand der Fig. 3 näher erläutert wird, sind zusammen mit einer isolierenden Zwischenlage Z zwischen den Halteschienen Hso und Hsu festgeklemmt. Durch die geschilderte Art der Stromübertragung mit Stromabnehmern Sao und Sau und Stromschienen Sso bzw. Ssu sowie durch die Anordnung der Schließfedern Sf können die Kontaktklemmen Kk für verschiedene Stärken der Leiterplatten Lp eingesetzt werden, ohne daß sich hierbei der Kontaktdruck wesentlich ändert.

Durch die Ausrüstung der Kontaktklemmen Kk mit Schließfedern Sf müssen die Kontaktklemmen Kk im Einaufbereich zum Erfassen der Leiterplatten Lp und im Auslaufbereich zur Freigabe der Leiterplatten Lp zwangsläufig geöffnet werden. Hierzu sind im Ein- und Auslaufbereich der Leiterplatten Kulissensteuerungen vorgesehen, deren Aufbau und Funktion aus der bereits erwähnten EP-A-0 254 962 hervorgehen.

Der Aufbau und die Form der oberen Stromschiene Sso mit den zugeordneten Kontaktfedern Kf geht aus Fig. 3 hervor. Es ist zu erkennen, daß die obere Stromschiene Sso aus einem massiven Kern K und einer Ummantelung U besteht und daß die jeweils mit einem sich in Längsrichtung erstreckenden Schlitz Sz versehenen Kontaktfedern Kf mit der Ummantelung U durch jeweils zwei Schweißpunkte Sp verbunden sind. Der Kern K der Stromschiene Sso besteht aus einem Material mit hohem elektrischen Leitvermögen, insbesondere Kupfer, während die Ummantelung U aus einem Material mit hoher Korosionsbeständigkeit, insbesondere Titan, besteht. Die zweifach abgebogenen Kontaktfedern Kf sind derart bemessen, daß sie an den zugeordneten oberen Stromabnehmern Sao (vergleiche Fig. 2) federnd anliegen und dabei den für die Stromübertragung erforderlichen Kontaktdruck aufbringen. Neben diesen federnden Eigenschaften müssen die Kontaktfedern Kf auch noch die erforderliche Korosionsbeständigkeit aufweisen, wobei Kontaktfedern Kf aus Titan beide Eigenschaften erfüllen. Es wäre aber auch möglich, die Kontaktfedern Kf aus einem elastischen Kern und einer korosionsbeständigen Ummantelung aufzubauen, wobei in sämtlichen geschilderten Fällen zusätzlich aber auch noch das erforderliche elektrische Leitvermögen gewährleistet sein muß.

Die vorstehenden Ausführungen zu der oberen Stromschiene Sso treffen auch für die in gleicher Weise ausgebildete untere Stromschiene Ssu zu.

Die geschilderte Stromzufuhr über einen titanummantelten Kupferstab mit daran angeschweißten Titanfedern verhindert eine zu starke Erhitzung im Bereich der Schleifkontaktierung und damit einen frühzeitigen Verschleiß, wobei gleichzeitig die erforderliche Korosionsbeständigkeit sämtlicher stromübertragender Teile gewährleistet ist.

## Patentansprüche

1. Galvanisiereinrichtung für im horizontalen Durchlauf zu behandelnde plattenförmige Werkstücke, insbesondere Leiterplatten, mit mehreren im Abstand zueinander seitlich mit dem Werkstück verfahrbaren Kontaktklemmen zur kathodischen Kontaktierung der durchlaufenden Werkstücke, wobei der Kathodenstrom den Kontaktklemmen über mindestens eine Stromschiene und über Kontaktorgane mittels Schleifkontaktierung zuführbar ist,
**gekennzeichnet durch**
folgende Merkmale:
a) die Stromschiene (Sso,Ssu) besitzt einen Kern (K) aus einem Material mit hohem elektrischen Leitvermögen und eine Ummantelung (U) aus einem Material mit hoher Korrosionsbeständigkeit,
b) als Kontaktorgane sind Kontaktfedern (Kf) vorgesehen, die aus einem Material mit hoher Korrosionsbeständigkeit bestehen,
c) die Kontaktfedern (Kf) sind mit der Stromschiene (Sso,Ssu) mechanisch und elektrisch leitend verbunden.

2. Galvanisiereinrichtung nach Anspruch 1,
**dadurch gekennzeichnet,**
daß der Kern (K) aus Kupfer oder einer Kupferlegierung besteht.

3. Galvanisiereinrichtung nach Anspruch 1 oder 2,
**dadurch gekennzeichnet,**
daß die Ummantelung (U) aus Titan oder einer Titanlegierung besteht.

4. Galvanisiereinrichtung nach einem der vorhergehenden Ansprüche,
**dadurch gekennzeichnet,**
daß die Kontaktfedern (Kf) aus Titan oder einer Titanlegierung bestehen.

5. Galvanisiereinrichtung nach einem der vorhergehenden Ansprüche,
**dadurch gekennzeichnet,**
daß die Kontaktfedern (Kf) durch Schweißen mit der Ummantelung (U) verbunden sind.

6. Galvanisiereinrichtung nach Anspruch 5,
**dadurch gekennzeichnet,**
daß die Kontaktfedern (Kf) durch Schweißpunkte (Sp) mit der Ummantelung (U) verbunden sind.

7. Galvanisiereinrichtung nach einem der vorhergehenden Ansprüche,
**dadurch gekennzeichnet,**
daß in die Kontaktfedern (Kf) mindestens ein sich in Durchlaufrichtung erstreckender Schlitz (Sz) eingebracht ist.

## Claims

1. Electroplating apparatus for plate-like workpieces, in particular printed circuit boards, to be treated while travelling through horizontally, which apparatus has a plurality of contact clamps for making cathodic contact to the workpieces travelling through, which contact clamps can be conveyed laterally with the workpiece at a distance from one another, it being possible for the cathode current to be fed to the contact clamps via at least one current rail and via contact elements by means of sliding contact, characterised by the following features:
a) the current rail (Sso, Ssu) has a core (K) made of a material having high electrical conductivity and a sheathing (U) made of a material having high corrosion resistance,
b) contact springs (Kf) comprising a material having high corrosion resistance are provided as contact elements,
c) the contact springs (Kf) are connected mechanically and in an electrically conducting manner to the current rail (Sso, Ssu).

2. Electroplating apparatus according to Claim 1, characterised in that the core (K) comprises copper or a copper alloy.

3. Electroplating apparatus according to Claim 1 or 2, characterized in that the sheathing (U) comprises titanium or a titanium alloy.

4. Electroplating apparatus according to one of the preceding claims, characterised in that the contact springs (Kf) comprise titanium or a titanium alloy.

5. Electroplating apparatus according to one of the preceding claims, characterised in that the contact springs (Kf) are joined to the sheathing (U) by welding.

6. Electroplating apparatus according to Claim 5, characterised in that the contact springs (Kf) are joined to the sheathing (U) by welding spots (Sp).

7. Electroplating apparatus according to one of the preceding claims, characterised in that at least one slot (Sz) extending in the direction of travel is provided in the contact springs (Kf).

## Revendications

1. Dispositif de galvanisation pour des pièces à traiter en forme de plaques, notamment des plaquettes à circuits imprimés, devant être traités au cours d'un déplacement horizontal, comportant plusieurs bornes de contact, à distance les unes des autres, déplaçables latéralement avec les pièces à traiter et servant à établir le contact cathodique avec les pièces en déplacement, le courant cathodique pouvant être envoyé aux bornes de contact par l'intermédiaire d'au moins un rail conducteur et par l'intermédiaire d'éléments de contact selon un contact glissant, remarquable par les caractéristiques suivantes :
a) le rail conducteur (Sso, Ssu) possède un noyau (K) réalisé en un matériau possédant une conductibilité électrique élevée, et une enveloppe (U) réalisée en un matériau possédant une résistance élevée à la corrosion,
b) comme éléments de contact, il est prévu des ressorts de contact (Kf), qui sont réalisés en un matériau possédant une résistance élevée à la corrosion,
c) les ressorts de contact (Kf) sont reliés mécaniquement et d'une manière électriquement conductrice au rail conducteur (Sso, Ssu).

2. Dispositif de galvanisation suivant la revendication 1, caractérisé par le fait que le noyau (K) est réalisé en cuivre ou en un alliage de cuivre.

3. Dispositif de galvanisation suivant la revendication 1 ou 2, caractérisé par le fait que l'enveloppe (U) est réalisée en titane ou en un alliage de titane.

4. Dispositif de galvanisation suivant l'une des revendications précédentes, caractérisé par le fait que les ressorts de contact (Kf) sont réalisés en titane ou en alliage de titane.

5. Dispositif de galvanisation suivant l'une des revendications précédentes, caractérisé par le fait que les ressorts de contact (Kf) sont réunis par soudage à l'enveloppe (U).

6. Dispositif de galvanisation suivant la revendication 5, caractérisé par le fait que les ressorts de contact (Kf) sont réunis à l'enveloppe (U) par des points de soudure (Sp).

7. Dispositif de galvanisaiton suivant l'une des revendications précédentes, caractérisé par le fait qu'au moins une fente (Sz), qui s'étend dans la direction de déplacement, est ménagée dans les ressorts de contact (Kf).
